# EUROPEAN PATENT APPLICATION

(11) **EP 4 198 476 A1**
(43) Date of publication of application: **21.06.2023**
(21) Application number: 21214671.6
(22) Date of filing: 15.12.2021
(51) Int. Cl.: G01L 1/16, G01L 5/167, G01P 15/09, H01L 41/08

(54) **STRAIN SENSOR AND STRAIN SENSOR ARRANGEMENT**

(71) Applicant: Sensirion AG, 8712 Stäfa (CH)
(72) Inventor: WINGER, Martin, 8712 Stäfa (CH)
(74) Representative: E. Blum & Co. AG

(57) **Abstract**

A strain sensor, comprises a substrate (1) and a strain sensing layer (2) of polycrystalline piezoelectric material. The strain sensing layer (2) is supported by the substrate (1) and extends in a plane in parallel to a plane (x,y) of the substrate (1). The strain sensing layer (2) is arranged between a top electrode (3) and a bottom electrode (4), each extending in parallel to the plane (x,y) of the substrate (1). The strain sensing layer (2) has a thickness of equal to or less than 2 µm perpendicular to its plane extension and is linked with the substrate (1) to have strain (ST) in the plane (x,y) of the substrate (1) couple into the strain sensing layer (2) as in-plane strain (ST). The polycrystalline piezoelectric material of the strain sensing layer (2) is configured to convert the in-plane strain (ST) in the strain sensing layer (2) into an electric field (EF) perpendicular to the plane of the strain sensing layer (2), resulting in a difference of potential between the top electrode (3) and the bottom electrode (4) representing a strain signal.

## Description

### Technical Field

The present invention relates to a strain sensor, a strain sensor arrangement, the use of a strain sensor, and a method for operating a strain sensor.

### Background Art

The most widespread work-horse for vibration sensing in industrial applications is a piezo-based accelerometer. In such a piezoelectric accelerometer, a seismic mass or a vibrating body presses on the piezoelectric material and causes compression therein when pressing the piezoelectric material against a mechanical stop. The compression in turn causes a voltage signal corresponding to the component of the compression force in direction of the deflection of the body / mass. These known accelerometers are bulky, require a defined interface between the vibrating mass or body and the piezoelectric material, and require sophisticated readout electronics.

### Disclosure of the Invention

The problem to be solved by the present invention is therefore to provide a sensor and a sensor arrangement enabling measurement of vibrations or structure borne sound and avoiding the above drawbacks.

This problem is solved by a strain sensor according to claim 1.

The strain sensor comprises a substrate and, supported by the substrate, a strain sensing layer of polycrystalline piezoelectric material arranged between a top electrode and a bottom electrode. Strain represents one of compression or stretching in a body and typically varies over time in case it is generated by vibrations and / or structure borne sound. Strain, hence, is dynamic strain, preferably oscillating strain, throughout the description of this invention. Strain may be coupled from a component - the strain of which is to be measured - into the strain sensor and hence into the strain sensing layer.

Presently, strain is considered as in-plane strain, i.e. as strain in an x/y plane that is desired to be measured. Any vibration or other oscillation in z-direction desired to be measured effects in-plane strain in x/y direction due to the Poisson effect.

For this purpose, a polycrystalline piezoelectric material is used for a strain sensing layer that is configured to convert strain in a plane of the strain sensing layer, also referred to as in-plane strain, into an electric field perpendicular to the plane of the strain sensing layer. An electrical strain signal results from a charge transfer in the polycrystalline piezoelectric material upon impact of the mechanical in-plane strain. The resulting charge Q leads, in combination with a capacity C of the piezoelectric material, to a voltage signal ΔV=ΔQ/C, i.e. a difference of electric potential between the top electrode and the bottom electrode representing the strain signal.

The substrate is a planar substrate given that its length and width extending in x- and y-direction exceeds its thickness perpendicular to the plane extension in z-direction, and preferably exceeds its thickness by a factor of more than 5. Preferably, the thickness of the substrate is equal to or less than 950 µm, preferably equal to or less than 300 µm, and on the other hand preferably is equal to or more than 50 µm, more preferably equal to or more than 90 µm. The strain sensing layer extends in a plane parallel to the plane of the substrate, i.e. also in x- and y-direction. In such case, the electric field is generated in z direction. In this regard, the in-plane strain is perpendicularly converted into a vertical electric field which effects different electric potentials at the top and the bottom electrode which can be sensed as a voltage strain signal. Hence, the strain sensing layer has a planar extension with only a little thickness or height of equal to or less than 2 µm, preferably between 100 nm and 2 µm, which is exceeded by its lateral extension in x/y direction. The strain sensing layer hence is a thin film layer, preferably manufactured by deposition.

The top and the bottom electrode each extends in x- and y direction, and, thus, is arranged in a plane in parallel to the planes of the substrate and the strain sensing layer. Given that the strain sensing layer has a dominant planar extension, the top electrode preferably is a planar electrode in contact with a top surface of the strain sensing layer. In a preferred embodiment, it completely covers the top surface of the strain sensing layer. The bottom electrode is a planar electrode, too, in contact with a bottom surface of the strain sensing layer. The bottom electrode preferably covers the entire bottom surface of the strain sensing layer, or, in another embodiment, covers more than 90% of the bottom surface of the strain sensing layer, in particular when the top electrode is guided down to the level of the bottom electrode at a front end of the strain sensing layer. A short between the top electrode and the bottom electrode can hence be avoided.

Accordingly, the bottom electrode is arranged between the substrate and the strain sensing layer, while the top electrode preferably is arranged on top of the strain sensing layer, facing away from the substrate. Preferably, the bottom electrode is deposited directly on the substrate. In a different embodiment, one or more other layers may be applied between the substrate and the bottom electrode, such as a seed layer or a CMOS layer stack that is deposited onto the top surface of the substrate. A thickness of each of the top electrode and bottom electrode perpendicular to its plane extension is between 100 nm and 1000 nm, and more preferably between 200 nm and 500 nm. Preferably, each of the top electrode and the bottom electrode extends across an area of at least 1 mm², preferably at least 2 mm², preferably less than 10 mm². Each of the bottom and top electrode may be embodied as continuous electrode across its extension; or, it may be represented by an array of smaller sized electrodes electrically interconnected with each other and in total fulfilling the size ranges introduced above.

In a preferred embodiment, also the strain sensing layer extends in x- and y- direction across an area of at least 1 mm², preferably at least 2 mm², preferably less than 10 mm². The strain sensing layer is linked with the substrate, and preferably laminar linked with the substrate to have strain in the plane of the substrate, again referred to as in-plane strain, coupled as in-plane strain into the strain sensing layer in case the strain is coupled into the strain sensing layer via the substrate. Accordingly, strain in the horizontal x/y plane in the substrate is coupled into the strain sensing layer as strain in its x/y plane. The coupling manifests in the in-plane strain on the top surface of the substrate being received by the bottom surface of strain sensing layer. Hence, a surface deformation of the substrate representing the strain is transmitted into the strain sensing layer. This is achieved by a rigid connection between the substrate and the strain sensing layer. For this reason, the strain sensing layer preferably is deposited directly on the substrate or on the bottom electrode, which in turn is deposited on the substrate. However, other layers may be deposited in between as long as the coupling is sufficient. Given that in-plane strain in the substrate shall transfer to the strain sensing layer, the strain sensing layer as well as the electrodes for measuring a significant signal are desired to extend across a considerable area such as indicated above.

In operation, it is preferred that the strain sensor is attached to or otherwise linked to a component the strain, or structure borne sound, or orthogonal vibrations / deflections are desired to be measured. Accordingly, the strain sensor is coupled to the component to receive in-plane strain of the component, which in-plane strain, again is defined as strain in the x/y plane. Other than such coupling, it is preferred that the strain sensor is free floating such that a vertical movement of the strain sensor, in and particular its strain sensing layer is not inhibited, while at the same time the vertical movement of the strain sensing layer strictly follows the vertical movement of the substrate and the vertical movement of the component by way of rigidly linking the strain sensing layer to the substrate and rigidly linking the strain sensor to the component. In other words, the strain sensor follows any deflection of the component in vertical z-direction, the deflection not being inhibited by a mechanical stop. This ensures, that the strain measured is not a result of a vertical compression of the strain sensing layer, but is a result of in-plane strain, and preferably dynamic in-plane strain.

Strain in the plane of the substrate and the strain sensing layer may be positive or negative, i.e. either tensile or compressive. The polycrystalline piezoelectric material has the effect to generate electric dipoles in response to in-plane stretching or compression of the material. Accordingly, the strain in the plane of the strain sensing layer is at least in part converted to an electric field perpendicular to the plane. The property of the perpendicular relation between in-plane strain and perpendicular electric charge within the strain sensing layer is quantified by the piezoelectric coefficient e₃₁. In addition, a longitudinal piezoelectric effect with coefficient e₃₃ may occur in the strain sensing layer, i.e. electric field in direction of strain, both of which perpendicular to the strain sensing plane. These properties are primarily affected by the choice of material and the thickness of the strain sensing layer. The different piezoelectric coefficients are further coupled to different geometrical-mechanical factors of the strain sensing layer and its boundaries, and hence constitute a sensing signal. Notably, even if material coefficient e₃₁ may not dominate over coefficient e₃₃ it is possible to construct a sensor predominantly sensing in-plane strain. This can be achieved by an adequate choice of material, thickness and geometry of the strain sensing layers and adjacent structures.

The crystalline structure of some polycrystalline piezoelectric materials enables such perpendicular coupling, even without applying an external electrical field. In such material, crystallites may have different orientations, however, the overall piezoelectric coefficient e₃₁ still is of sufficient magnitude for a perpendicular coupling. Preferably, many of the crystallites have the same orientation. Preferably, the crystallites of the polycrystalline material of the strain sensing layer show columnar shapes, and preferably a majority of such crystallites extend with their main axis in z-direction. Accordingly, a majority of the crystallites are preferably arranged columnar, preferably in z-direction perpendicular to the plane of the substrate.

In addition or alternatively, the polycrystalline piezoelectric material is prepared and arranged such that it comprises crystallites with a c-axis oriented perpendicular to the plane of the substrate. Preferably a majority of crystallites of the polycrystalline piezoelectric material show a c-axis oriented perpendicular to the plane of the substrate. AlN films prepared on a metal electrode with a face centered cubic lattice structure show a high c-axis orientation.

One of the materials preferred in this regard is aluminium nitride (AlN). The strain sensing layer may even consist of AlN, absent any other material. In a different embodiment, it may comprise AlN next to another type of material. AlN already shows good properties for the perpendicular coupling due to its microstructure. Preferably, the AlN is applied by reactive sputtering.

In a different embodiment, the strain sensing layer is made from an alloy. Preferably, scandium doped aluminium ScₓAl₁₋ₓN is used as piezoelectric material, in which the piezoelectric coefficient e₃₁ is increased in comparison with AlN. In a preferred variant, the strain sensing layer comprises equal to or less than 50% scandium, more preferably equal to or less than 45% scandium, and even more preferred equal to or less than 30% scandium. In a further embodiment, zinc oxide ZnO is used as piezoelectric material of the strain sensing layer. Such material may, e.g. be PZT, i.e. lead zirconate titanate Pb[ZrₓTi₁₋ₓ]O₃. In a different embodiment, Barium Titanate (BTO) is used as piezoelectric material.

Generally, plane or in-plane shall refer to the main dimensions of the respective part which typically exceed the corresponding perpendicular extension. Hence, the plane extension of the strain sensing layer is defined by its lateral extensions, as is the plane of the electrodes, the substrate, any other layer in the strain sensor, and the strain sensor. Hence, typically in-plane strain of a component to be measured occurs as in-plain strain at its top surface to which the strain sensor preferably is attached to in a strain sensor arrangement. The in-plane strain in the component will be coupled to in-plane strain in the substrate, and finally to in-plane strain in the strain sensing layer. The in-plane strain in the component may result from compression or tension forces acting onto the component in the plane. It is to be said, that even strain in perpendicular direction to the plane may generate a strain component in-plane given that any stretching or compression of the component in perpendicular direction comes along with a respective in-plane compression or stretching. Accordingly, also vibrations of the component in z-direction may equally be sensed by the strain sensor arrangement as dynamic in-plane strain as suggested.

Accordingly, while common accelerometers or vibration sensors directly measure the vertical dynamic displacement of a body, it is presently proposed to detect a local dynamic surface strain accompanying a vibration, which may also include structure borne sound. This is achieved by a sensitive polycrystalline piezoelectric layer disposed on the substrate. The perpendicular piezoelectric effect translates in-plane dynamic strain in the strain sensing layer into an out-of-plane dynamic electric field that gives rise to a voltage between preferably planar electrodes on top and below the polycrystalline piezoelectric layer. Since it is not envisaged to sense a perpendicular force of a body directly by means of the piezoelectric material thereby being compressed or stretched or deflected in the same direction the body deflects, a thin-film polycrystalline piezoelectric layer is used. This thin-film polycrystalline piezoelectric strain sensing layer primarily measures strain in a direction in the plane of the polycrystalline piezoelectric layer, and hence in-plane directed strain, instead of perpendicular forces. Also owing to the planar extension of the polycrystalline piezoelectric layer, in-plane sensitivity wins over perpendicular sensitivity.

Since deflections in z-direction are not desired to heavily impact the measurement result, the strain sensing layer not only is thin in z-direction but substantial in x- and y- direction. In addition, it is abstained from mounting the strain sensing layer oscillating on the substrate. Instead, the strain sensing layer is rigidly linked with the substrate and only follows motions of the substrate itself but shows no relative movement with respect to the substrate. Accordingly, the strain sensing layer is not supported by a membrane or diaphragm on / of the substrate. I.e. there is no recess or cavity in the substrate underneath the stress sensing layer. Instead, the stress sensing layer is fully supported by the substrate across its entire extension in the x/y plane, in particular by the bulk substrate that is defined as solid substrate material representing a portion of a wafer. The polycrystalline piezoelectric material is planar deposited directly or via other layers on the substrate, with a good perpendicular coupling, i.e. in-plane strain is converted into a perpendicular electrical field. This allows the integration of the strain sensing layer on a semiconductor chip, for example.

This allows for a compact strain sensor, small in size, e.g. less than 10 mm times 10 mm in the plane, and more preferably less than 2 mm times 2 mm in the plane, and in one embodiment, including a comfortable readout electronics at the location of the sensor, i.e. integrated in the substrate. In particular, the strain sensor is attached perpendicularly floating to the component that shall be measured. In other words, this means, that its attachment preferably is a laminar, in-plane interface such that in-plane strain of the component is coupled into the strain sensor as in-plane strain, while a displacement or deformation of the component perpendicular to its plane is joined in by the strain sensor and in particular by its strain sensing layer. Still, a perpendicular displacement of the component, such as in case of vertical vibrations, translates into in-plane strain yet at the component, which then will be transmitted by suitable coupling as in-plane strain into the strain sensing layer, the measurement properties of the strain sensing layer making the in-plane strain dominate over any vertical strain. Hence, neither the strain sensor nor its strain sensor layer neither becomes stretched nor compressed nor deflected relative to the substrate in response to perpendicular displacement or perpendicular strain of / in the component. A corresponding mounting of the strain sensor may include, that it is absent any clamping or counterforce or mechanical stop in perpendicular / vertical direction. In this sense, the strain sensor is arranged free floating on the component to be measured. It is sufficient to have the strain sensor coupled and / or mounted to the component either at its bottom surface or at its top surface, which surfaces are assumed to be in parallel with the strain sensing layer. Such mounting preferably includes one or more mounting elements that are exclusively arranged at the top surface of the strain sensor or at its bottom surface, wherein the top surface in one embodiment is represented by a package for the strain sensor chip. The mounting elements are preferably provided to fix the planar position of the strain sensor chip relative to the component in order to couple in-plane strain from the component into the strain sensor and in particular into the plane of the strain sensing layer. In one embodiment, the strain sensor is attached to the component all across its bottom surface, or all across its top surface, e.g. by gluing. Here, the coupling between the strain sensor and the component is planar again. All these means provide for coupling strain in x/y direction at the top surface of the component into in-plane strain of the strain sensing layer and / or the substrate.

However, it is preferred to not have any mounting elements that are provided or arranged to retain the strain sensor and/or the strain sensing layer at a defined perpendicular position, such as a mechanical stop. It is desired to have the strain sensor follow and coincide with any perpendicular movement or perpendicular displacement or perpendicular extension of the component, absent any restriction of the deformation of the strain sensing layer in perpendicular direction. In particular, the strain sensor is attached to the component at its bottom surface such that the strain sensing layer faces away from the component. Hence, a direct measurement of strain is provided rather than using strain as proxy for pressure or force.

The present integrated strain sensor provides at least a sensing performance comparable to standard piezo-accelerometers at a substantially lower volume. This allows a user to increase the number of data collection nodes, which is particularly beneficial for applications in the field of predictive maintenance.

By measuring strain in x/y direction rather than accelerations in z-direction, it was also found that the present strain sensor is capable of measuring vibration induced strain at frequencies substantially higher than in conventional vibration sensors that focus on the direct detection of accelerations along the z-axis. Conventional vibration sensors typically cannot sense vibration frequencies beyond 25 kHz due to the inertia of the seismic mass and / or the inertia of the sensing element deflecting in z-direction. In contrast, the present strain sensor senses changes in the strain beyond this limit, and in particular up to several 100 kHz, preferably up to 500 kHz, owing to the concept of sensing in-plane strain in and by a non-deflecting strain sensing layer rather sensing motions of a deflecting strain sensing layer. Accordingly, this advantage of the present strain sensor allows for new applications in high-frequency vibrations sensing.

Preferably, each of the top electrode and the bottom electrode comprises or consists of molybdenum. In different embodiments, each of the top and the bottom electrode comprises or is made of one of Al, Pt, W, AlCu, Ag, Au/Ti, Co, Cr, Cu, Fe, Nb, Pt/Ti, Ti, W, Zn, Zr. Preferably, a thickness of each of the top electrode and the bottom electrode is between 100 nm and 1 µm, more preferably between 200 nm and 500 nm. Preferably, the top electrode is thicker than the bottom electrode, since it additionally may serve as etch stop for possible further layers on top of the top electrode. Preferably, the strain sensing layer comprises or is made from AlN, the bottom electrode comprises or is made from Mo, and the top electrode comprises or is made from Mo or from Al. These are preferred combinations in that the crystalline phase of the bottom electrode affects the crystalline structure of the strain sensing layer. Hence, Mo and AlN, or Pt and AlN have similar crystalline phases and hence match in achieving the desired properties of the strain sensing layer. The top electrode may be made from the same material as the bottom electrode, according to one embodiment. According to a different embodiment, the top electrode is made from Al, which can be deposited via a common depositing tool as the strain sensing layer, in case the strain sensing layer is made from AlN.

The coupling in the strain sensing layer can be enhanced by a proper processing of the polycrystalline piezoelectric material. In particular, it is preferred to have a seed layer of the same piezoelectric material the strain sensing layer made from deposited on the substrate or on any layer in between. This in particular is preferred in case the piezoelectric material is AlN or ScAlN. The seed layer preferably is applied underneath the bottom electrode, e.g. directly on the substrate. Preferably the seed layer has a thickness of only between 10 nm and 50 nm. Although not in direct contact with the strain sensing layer the seed layer promotes the crystalline growth and in particular the proper orientation of the crystallites even through the bottom electrode. The crystalline structure of the bottom electrode, when grown on top of the seed layer, is affected by the crystalline structure of the seed layer. The crystalline orientation of the bottom electrode in turn promotes the same crystalline orientation in the strain sensing layer. Accordingly, the seed layer promotes the crystalline growth in the strain sensing layer through the bottom electrode.

In a very preferred embodiment, AlN or ScAlN and Mo are materials that can be grown on top of each other and follow the crystalline orientation of the layer underneath. Hence, in the above preferred embodiment, the seed layer is made from AlN or from ScAlN, the bottom electrode is made from Mo on top of the seed layer, the strain sensing layer is made from AlN or ScAlN respectively on top of the bottom electrode, and the top electrode is made from Mo or from Al on top of the strain sensing layer.

Preferably, the substrate is a semiconductor substrate, more preferably a silicon substrate, and most preferably a silicon substrate with an orientation of <001> in Miller indices. This allows the crystalline orientation of the subsequently deposited layers e.g. of seed layer, bottom electrode and / or strain sensing layer to be impacted to generate or promote the desired perpendicular coupling.

In order to enhance the strain propagation in the strain sensor, it is preferred to make the substrate rather thin as laid out above. This is preferably achieved by grinding a thicker standard substrate. This improves the in-chip propagation of strain without excessive relaxation. At least the portion of the substrate the strain sensing layer is linked with or is attached to represents bulk substrate material absent any undercut, cavity or recess therein.

In some embodiments, the substrate may be part of a strain sensor chip containing integrated circuitry, preferably fabricated by using CMOS technology and CMOS processing steps. In such embodiment, the strain sensor chip may comprise an interconnect stack of alternating electrically conducting and dielectric layers, and possibly vias such as tungsten plugs for electrically connecting metal layers of different levels with each other. The interconnect stack may be manufactured on a side of the substrate that is referred to as front side in the following, which is the side the electronic circuitry is integrated in. The bottom electrode may be manufactured on the interconnect stack. The interconnect stack may electrically connect the top and the bottom electrode to the electronic circuitry.

The electronic circuitry preferably is configured to process the strain signal. Processing may include pre-processing the strain signal and/or evaluating the strain signal as to its characteristics.

Preferably, the top electrode is connected to ground potential. In this embodiment, it is preferred that the top electrode at the same time represents an ESD protection element protecting the strain sensing layer and the electronic circuitry from electric discharge and / or an element for electromagnetic compatibility protecting the strain sensing layer and electronic circuitry if any from interfering electromagnetic fields.

In one embodiment, the strain sensor comprises a protection layer. The protection layer may be one of a mold compound and a glob top. The protection layer preferably encapsulates parts of the substrate and may also cover the top electrode. In particular when covering the top electrode, a thickness at least of the portion of the glob top covering the top electrode is less than 5 mm, preferably less than 2 mm, preferably between 300 µm and 600 µm. A glob top preferably is understood as a drop shaped encapsulation of a material comprising epoxy, which is rather soft, e.g. showing a modulus of elasticity between 15 and 14000 MPa. Instead, the modulus of elasticity of a mold compound may be between 8000 and 40000 MPa.

The strain sensor may be directly or indirectly placed on a component to measure the strain of. In particular when desired to be encapsulated, the substrate is placed on a die pad of a lead-frame. The strain sensor including the die pad then is encapsulated by means of a mold compound thereby building a package for the strain sensor. The package preferably fully encapsulates the substrate and the strain sensing layer. Prior to molding, wire bonds may be applied from bond pads formed on the substrate down to the lead-frame, and in particular to contact pads of the lead-frame. Hence, such wire bonds are also encapsulated by the package. Preferably, the packaged strain sensor chip is embodied as QFN (Quad Flat No Leads) or as DFN (Dual Flat No Leads). By means of the package, the strain sensing layer is protected and the strain sensor can safely be mounted to the component.

Hence, the strain sensor can be mounted to the component without needing a counter bearing or an end support for providing a counterforce in case of the component being arranged to exert a perpendicular pressure on the strain sensing layer. Instead, it is assumed that the strain of the component is received by some intermediate means or mounting elements such as a carrier for the strain sensor etc., and then coupled into the substrate. The strain then is coupled from the substrate to the strain sensing layer, where it is measured. The measured strain preferably is proportional to the strain in the component. In a different embodiment, the strain sensor is mounted directly or indirectly to the component with its package facing the component, and by means of mounting elements, such as an adhesive between the component and the package. Strain of the component is received by the package via the mounting elements and is coupled from the package into the strain sensing layer, where it is measured. A combination of the strain sensor attached to and coupled with the component is presently claimed as strain sensor arrangement.

The mounting elements may in particular comprise a housing for the strain sensor, e.g. made from steel. Such housing is suited for propagating strain from the component to the strain sensor. On the other hand, the housing protects the strain sensor, and prevents from coupling perpendicular strain into the strain sensor.

In addition, the mounting elements may include a circuit board for supporting the strain sensor and at the same time electrically connecting to the strain sensor, such as a printed circuit board, and in particular a flexible printed circuit board. The circuit board is arranged inside the housing, and e.g. electrically connects to an electrical connector arranged in a wall in the housing.

Accordingly, in an embodiment an arrangement is claimed in which the strain sensor, such as the packaged strain sensor described above, is SMD mounted via its lead-frame to the circuit board, which circuit board is attached to the wall of the housing that is attached and coupled to the component. Hence, in this embodiment, strain is coupled from the component into the housing, from the housing into the circuit board, from the circuit board into the strain sensor, e.g. its lead-frame first. In a different embodiment of an arrangement, the same packaged strain sensor again is mounted on a circuit board, which electrically connects to a connector of the housing. However, now it is not the circuit board that is attached to the wall of the housing but it is the strain sensor itself that is attached and coupled to the wall of the housing that faces the component. Hence, the strain sensor is attached to the wall of the housing by means of its package, i.e. in a flipped configuration compared to the above arrangement. In this embodiment, strain is coupled from the component into the housing and from the housing into the package of the strain sensor.

In a further embodiment of an arrangement containing the strain sensor arranged in a housing, the strain sensor is embodied as strain sensor chip without any package or lead-frame. Such bare die strain sensor may be SMD mounted onto a circuit board such as a flexible printed circuit board in a "chip-on-board-mount". The circuit board is attached to the wall of the housing facing the component. In this embodiment, the strain sensor is mounted onto the circuit board with its substrate facing the circuit board, hence, the strain sensing layer facing away from the circuit board. In this embodiment, strain is coupled from the component into the housing, from the housing into the circuit board, and from the circuit board into the strain sensor chip, e.g. its substrate first.

In a further embodiment of an arrangement, the strain sensor again is embodied as bare strain sensor chip without any package or lead-frame. Such bare die strain sensor now is not mounted on a circuit board but instead is mounted directly onto the housing wall facing the component. Facing the component shall mean is attached to the component. In this embodiment, strain is coupled from the component via the housing wall directly into the strain sensor chip, preferably into its substrate first. In this embodiment, it is preferred that still a circuit board is provided inside the housing, which e.g. may be mounted onto the same wall.

In a different variant, the substrate is arranged between the sensing stack and an interconnect stack. Such arrangement can also be referred to as flip-chip arrangement. In one embodiment thereof the interconnect stack faces a carrier for electrically connecting the strain sensor, while the strain sensing layer faces the component to be measured. In this embodiment, a redistribution layer may be deposited on the interconnect stack, solder balls may be attached to the redistribution layer, and e.g. a flexible printed circuit board serves as carrier to which the strain sensor is mounted via the solder balls. In a different embodiment, the interconnect stack faces the component to be measured, and contact means such as solder balls are mounted, e.g. to a redistribution layer which in turn is applied to the top of the interconnect stack for electrically and mechanically connecting and coupling the strain sensor chip to the component. In this variant, it is envisaged that the substrate comprises through-vias, in particular silicon-through-vias, which are configured as metallized holes through a thickness of the semiconductor substrate. Since the sensor stack is attached to the bottom side of the substrate, e.g. after planarizing the bottom side of the substrate, the top electrode and the bottom electrode are electrically connected to the interconnect stack through different through-vias. The interconnect stack then electrically connects the through-vias to an electronic circuitry either integrated in the substrate or outside the substrate, such that the strain signal from the electrodes can be processed in the electronic circuitry.

Accordingly, it is preferred that in-plane strain in the component desirably is coupled as in-plane strain in the strain sensor layer. Accordingly, the strain sensor follows the in-plane strain of the component by means of mechanical coupling to the component. Also within the strain sensor, the in-plane strain desirably is coupled from the substrate into the strain sensing layer, in case the substrate is coupled with the component rather than the strain sensing layer.

Accordingly, in one embodiment, the strain sensor is mountable to the component by one or more mounting elements which are arranged at a top surface of the strain sensor or at its bottom surface. The strain sensor is directly or indirectly attached to the component via one or more mounting elements. The mounting and/or attachment is such that the strain sensor joins in a perpendicular displacement or perpendicular extension of the component without being stretched or compressed. In particular, no means are provided for retaining the strain sensor and/or its strain sensing layer in a fixed perpendicular position. On the other hand, it is preferred that the strain sensor is mounted and/or attached to the component such that in-plane strain in the component is coupled into in-plane strain in the strain sensor chip.

In a preferred embodiment, the one or more mounting elements attach the strain sensor to the component at at least two mounting points in the plane. This evokes the in-plane coupling from the component into the strain sensor. Especially, the entire bottom or top surface may be attached to the component, e.g. by an adhesive. This again enables any in-plane stretching or compression in the component to couple into the plane of the strain sensor.

In one embodiment, the substrate of the strain sensor chip faces the component and the strain sensing layer of the strain sensor chip faces away from the component. In this embodiment, the strain sensing layer and the top electrode are preferably out of contact with the component.

According to a further aspect of the present invention, a strain sensor according to any of the preceding embodiments is used for measuring strain or for measuring vibrations. The component may be, or may be coupled to one of a machine, a tool, a production site, an infrastructure, an engine, a pump, a turbine, a bearing, a housing, a gear, a transportation means, and a vehicle, without limitation. Infrastructure may include, for example, a bridge, a power plant, or a wind engine. Transportation means may include transportation means for humans, including for example, a train, an underground, or for objects, including, for example, a baggage claim system, a sorting system, e.g. used for sorting mail, a filling line, etc. Given these components or systems are mechanical systems preferably being actuated, e.g. being translatory or rotatory actuated, or containing translatory or rotatory actuated elements coupled with the component, these systems and / or components thereof undergo mechanical stress e.g. caused by vibrations.

In turn, the magnitude of or pattern in the strain sensor signal representing such mechanical stress can be an identifier for the condition and / or the quality of such component or system. Accordingly, it is preferred that not only is the strain measured in such strain sensor arrangement, but also is the strain sensor signal evaluated, preferably by applying algorithms executed by a processing unit, for monitoring the condition and / or quality of the component or the system. For example, a magnitude and / or frequency of an oscillating strain sensor signal may be derived for classifying a condition or quality of the component, for example. For identifying the condition and / or quality, one or more measurements may need to be taken and evaluated. For example, a current measurement may allow determination of the condition or quality in some systems, while in other systems, multiple measurements may need to be taken over time, e.g. over a couple of hours or days, in order to allow for identifying a condition or quality of such component or system.

The condition and / or quality as laid out above may result in a condition or quality index value. Subject to the condition or quality index value determined, a recommendation may be given to an operator, and / or a control action may be initiated with respect to the system, and / or a recommendation for predicting maintenance operations for such component or system may be given, all, preferably, computerized. The recommendation to the operator may include an advice to one of increase, decrease power applied to the system, or to shut down the system, for example. The same actions may, in a different embodiment, automatically be initiated by the system. For example, in case the measured strain exceeds a given level for a defined period in time, a critical condition is detected and the system is shut down automatically. Hence, the signal of the strain sensor may also be used for controlling a process, preferably a process the component is effected by in terms of vibrations. In a different embodiment, the evaluated strain sensor signal may provide information as to a quality of the monitored component or system.

The present strain sensor can also be used for measuring structure borne sound and / or noise. In such application, the signal of the strain sensor may indicate a measure of quality of the monitored component, or of the monitored object the component is coupled to. For example, by mounting the strain sensor on a vehicle road noise can be measured and the condition of the road can be monitored by evaluating the measured structure borne sound of the vehicle. Possibly, active noise cancellation may be controlled in the vehicle dependent on the signal of the strain sensor. The component may also include a bridge or a building or other construction propagating structure borne sound. The signal of the strain sensor can then be taken as an indicator of the quality of living in or near such construction.

In the same manner the strain sensor can be mounted to a transportation means such as a container for measuring the structure borne sound during transportation of the container. This enables monitoring the condition of rails, tracks or other guide means the container is driven on. In a different application, the strain sensor may be applied to a component including one of a boiler, a heater and a burner, also for measuring structure borne sound. In these examples, the measured structure borne sound may represent a state of the component and be used for controlling the component or the system the component is part of.

The strain sensor may also be applied to a living being, such as a human being, for measuring structure borne sound and / or noise that may propagated e.g. in bones of the living being. The measured strain sensor signal may be used to implementing a hearing aid function and / or a noise cancellation function for the living being.

According to a further aspect of the present invention, a method is provided for operating a strain sensor according to any of the preceding embodiments. The strain sensor is attached to a component such that in-plane strain in the component is coupled into in-plane strain in the strain sensing layer. The subsequent steps are preferably implemented computerized: A strain sensor signal is received from the strain sensor and is evaluated, preferably by a processing unit in a cloud computing system. An index of condition and / or an index of quality is determined dependent on the evaluation of the strain sensor signal. One or more of the following steps are performed, wherein not all alternatives are to be implemented concurrently: The determined index is displayed. A recommendation is to an operator subject to the determined index. A process for operating the component or a system coupled to the component is adjusted subject to the determined index.

Other advantageous embodiments are listed in the dependent claims as well as in the description below.

### Brief Description of the Drawings

The invention will be better understood and objects other than those set forth above will become apparent from the following detailed description thereof. Such description makes reference to the annexed drawings, wherein:
Figure 1 illustrates a strain sensor in a cut view, according to an embodiment of the present invention,
Figure 2 illustrates a strain sensor in a cut view, according to an embodiment of the present invention,
Figure 3 illustrates a strain sensor in a cut view, according to an embodiment of the present invention,
Figure 4 illustrates a strain sensor in a cut view, according to an embodiment of the present invention,
Figure 5 illustrates a strain sensor arrangement in a cut view, according to an embodiment of the present invention,
Figure 6 illustrates a strain sensor arrangement in a cut view, according to another embodiment of the present invention,
Figure 7 illustrates a strain sensor arrangement in a cut view, according to a further embodiment of the present invention,
Figure 8 illustrates a strain sensor arrangement in a cut view, according to another embodiment of the present invention,
Figure 9 illustrates a strain sensor in a cut view, according to another embodiment of the present invention, and
Figure 10 illustrates a strain sensor in a cut view, according to another embodiment of the present invention.

### Modes for Carrying Out the Invention

Same reference signs across the Figures refer to same elements.

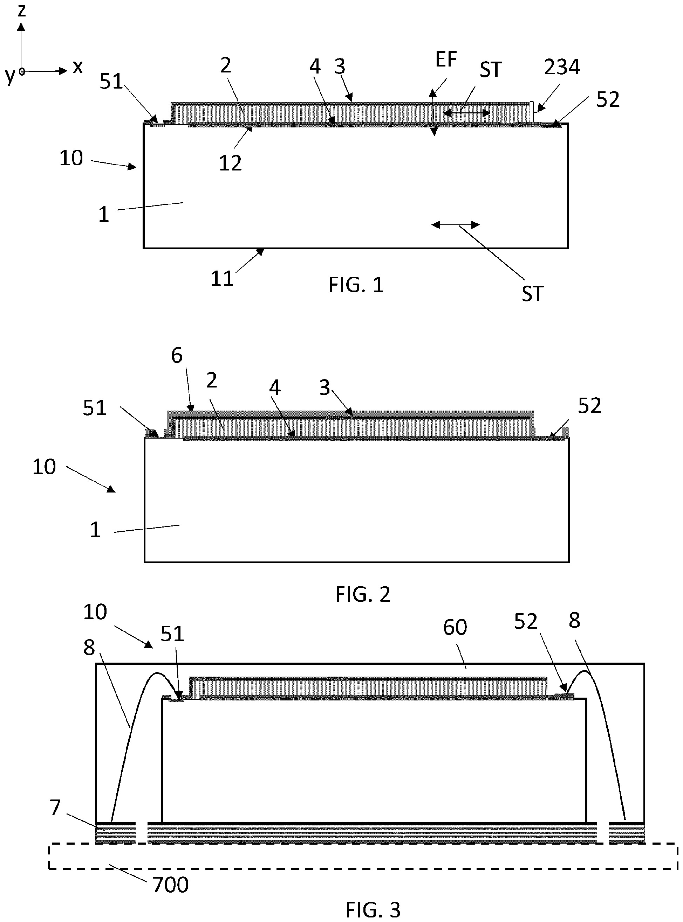

Figure 1 illustrates a cut view of a strain sensor 10 according to an embodiment of the present invention. The strain sensor 10 comprises a substrate 1 with a backside 11 and a front side 12. The substrate 1 is a semiconductor substrate.

A sensor stack 234 is arranged on top of the substrate 1. The sensor stack 234 comprises a polycrystalline strain sensing layer 2 which is sandwiched between a top electrode 3 and a bottom electrode 4. The strain sensing layer 2 presently is made from the piezoelectric material aluminium nitride AlN in a polycrystalline structure.

Given that the substrate 1 has a planar extension in x,y direction, the strain sensing layer 2 has so, too. I.e. its thickness in z-direction is much smaller than its planar extensions in x- and y-direction. The material of the strain sensing layer 2 is configured such that strain ST in the lateral plane x,y, which is indicated by a double arrow, is converted into an electrical field EF perpendicular to the x,y plane, i.e. in z-direction. Accordingly, a difference in electrical potential can be monitored at the top and the bottom electrode 3, 4.

The top electrode 3 and bottom electrode 4 are planar electrodes that cover more or less the entire top and bottom surfaces of the strain sensing layer 2. In the present example, the bottom electrode 4 does not cover the bottom surface of the strain sensing layer 2 completely given that otherwise it would short circuit with the top electrode 3 that is pulled down at a side surface of the strain sensing layer 2. The top electrode 3 is electrically connected to contact point 51 which may serve as bond pad. The bottom electrode 4 is electrically connected to contact point 52, which may serve as bond pad. Electrical signals may be transmitted to the outside of the strain sensor 10 via a wire bond.

In one embodiment, it is envisaged to mount the strain sensor 10 of Figure 1, e.g. packaged or unpackaged, or housed or unhoused, to a component, the strain of which component is desired to be sensed. Preferably, the strain sensor 10 rests on the component, e.g. directly or by mounting elements such as an adhesion layer, a housing wall, a printed circuit board or a flexible printed circuit board, etc. In such application, strain from the component may be transferred via the mechanical coupling from the component to the substrate 1, see double strain arrow ST. Such strain ST is further propagated to the stress sensing layer 2. In the strain sensing layer 2 the strain ST is converted into an electrical field EF perpendicular to the plane x,y of the strain sensing layer 2. The corresponding voltage is supplied as difference in potential between the top and the bottom electrode 3,4.

Figure 2 illustrates another embodiment of a strain sensor 10 in a cut view. This strain sensor 10 is identical to the strain sensor 10 of the first embodiment in Figure 1, except for a protection layer 6 applied to the top electrode and the front end of the strain sensing layer 2. Such protection or passivation layer 6 may be made from SiO2 and/or from SiN. In case the strain sensor 10 is attached to a component with the sensing stack 234 facing the component, the passivation layer 6 protects the top electrode 3 and the strain sensing layer 2. In one example, the strain sensor 10 can be directly attached to the component or to a mounting element such as a housing by means of the passivation layer 6, and an adhesive layer in between.

Figure 3 illustrates a strain sensor 10 in cut view according to an embodiment of the present invention. The strain sensor 10 includes a substrate 1 and a strain sensing layer 2 sandwiched between a top electrode 3 and a bottom electrode 4. The strain sensor 10 is the same as the strain sensor 10 of Figure 1 or Figure 2. The substrate 1 is arranged on a lead-frame 7, and in particular on a die pad of the lead-frame 7. Electrical connections between the contact pads 51,52 and contact pads of the lead-frame 7 are embodied as wire bonds 8. In an additional step, the lead-frame 7 and the strain sensor 10 are packaged in a package 50 made from a mold compound. The mold package 50 covers the entire substrate 1 except where it sits on the lead-frame 7, and covers the strain sensing layer 2 and exposed top surfaces of the lead-frame 7 as well. Hence, the strain sensor 10 may be SMD mounted onto a component to measure. Or, as indicated by the dashed lines in Figure 3, the strain sensor 10 may include a carrier such as a printed circuit board PCB 700, such that the PCB 700 sits on and is attached to the component to measure.

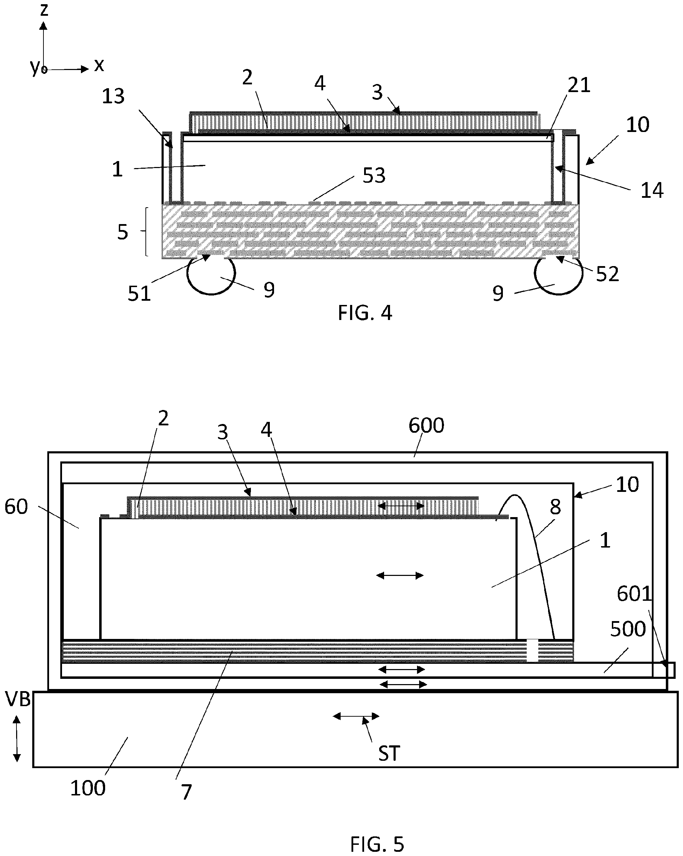

Figure 4 illustrates a strain sensor 10 in cut view according to another embodiment. The strain sensor 10 differs from the strain sensor 10 of Figure 1 in that an interconnect stack 5 is arranged on the substrate 1. Preferably, electronic circuitry 53 is integrated in the substrate 1, via CMOS processing, for example, and the interconnect stack 5 may be CMOS compatible as well, as is the manufacturing of the strain sensing layer 2. Of course, in case electronics shall be implemented in the substrate for building a strain sensing chip, this feature is applicable in combination with any of the other embodiments as well. In such embodiments, the strain sensing layer may also be attached on the interconnect stack 5 subject to the design and orientation desired. Presently, however, the interconnect stack 5 faces a circuit board (not shown) to be mounted on. Solder balls 9 are attached to bond pads 51,52 in a top most metal layer of the interconnect stack 5. Such solder balls 9 can be regarded as contact elements for electrically contacting the strain sensor 10.

Presently, a seed layer 21 is deposited on the substrate 1 prior to depositing the bottom electrode 4. The electrical signals of the top and the bottom electrodes 3,4 are routed to metal layers of the interconnect stack 5. For this purpose, through-vias 13 and 14 are provided. The through-vias 13,14, or silicon-through-vias in case of a silicon substrate, are represented by holes through a width of the substrate 1. Such holes are coated with metal. In the present example, the top electrode 3 is connected to the through-via 13, while the bottom electrode 4 is connected to the through-via 14.

Figure 5 illustrates a strain sensor arrangement in cut view, according to an embodiment of the present invention. The strain sensor arrangement comprises a strain sensor 10 identical or similar to the strain sensor shown in Figure 3 which is arranged on a component 100. The component 100 is exposed to dynamic strain ST in direction of the double arrow, but not limited to. The strain sensor 10 contains a substrate 1 with a package 50 arranged on a lead-frame 7. In the present example, the strain sensor 10 is SMD mounted to a carrier, which is in the present example is a flexible printed circuit board (PCB) 500. The mounting may include solder connections between the contact pads of the lead-frame 7 and contact pads of the flexible printed circuit board 500, not shown in Figure 5. By this means, an electrical connection is achieved between the strain sensor 10 and the flexible PCB 500 such that the processed strain signal may be available outside the strain sensor 10 and e.g. be conducted via the flexible PCB to a microcontroller either resident on the flexible PCB 500 or remote. The flexible PCB 500 in turn is attached to an inner wall of a housing 600. The flexible PCB 500 is electrically connected to a connector 601 resident in a wall of the housing 600. The housing 600 is attached to the component 100, e.g. by glue.

The strain ST in the horizontal plane x,y of the component 100, also referred to as in-plane strain ST propagates through the housing 600 and the flexible PCB 500, collectively referred to as mounting elements, via the lead-frame 7 to the substrate 1, and further on through the substrate 1 to the strain sensing layer 2, all as indicated by the double arrows. In the strain sensing layer 2, the in-plane strain ST in x,y plane is converted in the perpendicular electrical field EF as also indicated in Figure 1. However, the strain ST in the horizontal plane x,y of the component 100 may, in one embodiment, not necessarily result from compression or tension forces directly acting on the component 100 in x/y direction. As indicated by the double arrow VB, the component 100 may, for example, vibrate or oscillate in vertical direction, such that vertical dynamic strain is generated as a result from the vibration. In view of the Poisson effect, this vertical strain also effects a corresponding horizontal dynamic strain ST in the x/y-plane, which is the strain ST presently measured by the strain sensor 10. Since there is no mechanical stop or any other means that allows the vertical strain directly to directly act on the strain sensing layer 2, it is indeed the in-plane strain in x/y direction that is measured by the present strain sensing layer 2.

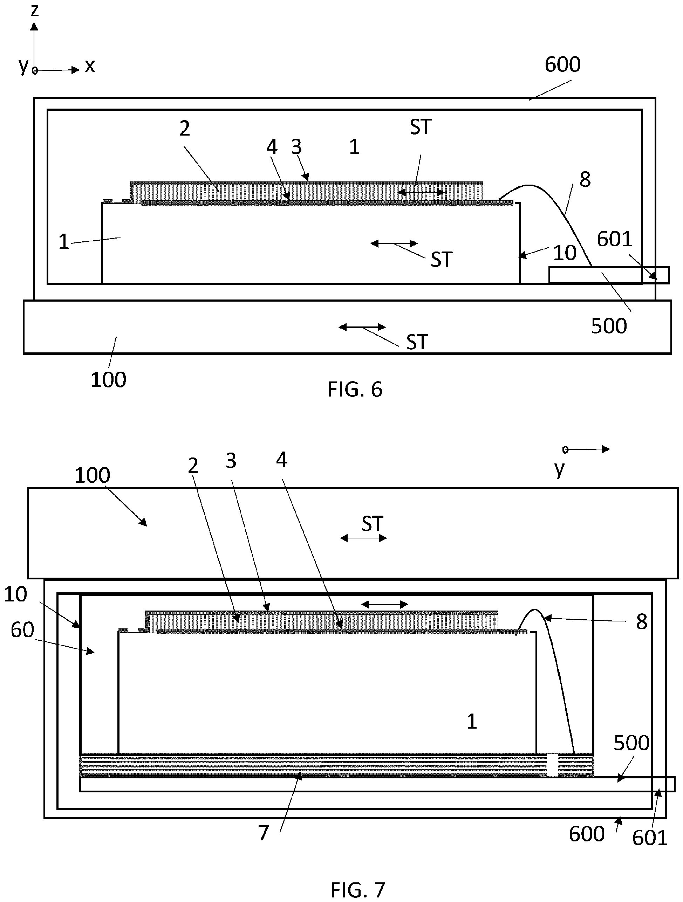

Figure 6 illustrates a strain sensor arrangement in cut view, according to another embodiment of the present invention. The strain sensor arrangement comprises a strain sensor 10 identical or similar to the one shown in Figure 1 or Figure 2 which is arranged as bare die onto an inner wall of a housing 600. The housing 600 in turn is attached to a component 100. The component 100 is exposed to strain ST in the direction of the double arrow, but not limited to. By means of wire bonds 8 an electrical connection is achieved between the strain sensor 10 and a flexible PCB 500 or interposer PCB attached to the same inner wall of the housing 600, such that the processed strain signal may be available outside the strain sensor 10 and e.g. be conducted via the flexible PCB 500 to a microcontroller either resident on the flexible PCB 500 or remote. The flexible PCB 500 is electrically connected to a connector 601 of the housing 600.

Figure 7 illustrates a strain sensor arrangement in cut view, according to an embodiment of the present invention. The strain sensor arrangement comprises a strain sensor 10 identical or similar to the strain sensor shown in Figure 3 which is arranged on a component 100. Accordingly, the embodiment is similar to the embodiment of Figure 5. However, in comparison to the embodiment of Figure 5, the strain sensor 100 now is flipped and attached to the inner wall of the housing 600 by means of its package 50. Hence, the strain sensing layer 2 is closer to the component 100 since the wall of the housing 600 the strain sensor 10 is attached to is mounted to the component 100 as is shown in Fig. 7. A height of the package 50 above the top electrode 3 may be adjusted for an optimal coupling / sensitivity. Again, the component 100 is exposed to dynamic strain ST in direction of the double arrow, but not limited to. The strain sensor 10 again is SMD mounted to a carrier, which in the present example is a flexible printed circuit board (PCB) 500. The mounting may include solder connections between the contact pads of the lead-frame 7 and contact pads of the flexible printed circuit board 500, not shown in Figure 7. By this means, an electrical connection is achieved between the strain sensor 10 and the flexible PCB 500 such that the processed strain signal may be available outside the strain sensor 10 and e.g. be conducted via the flexible PCB to a microcontroller either resident on the flexible PCB 500 or remote. The flexible PCB 500 in turn is lead to a connector 601 of the housing 600. The flexible PCB 500 is not necessarily fixed to the housing 600 other than to the connector 601.

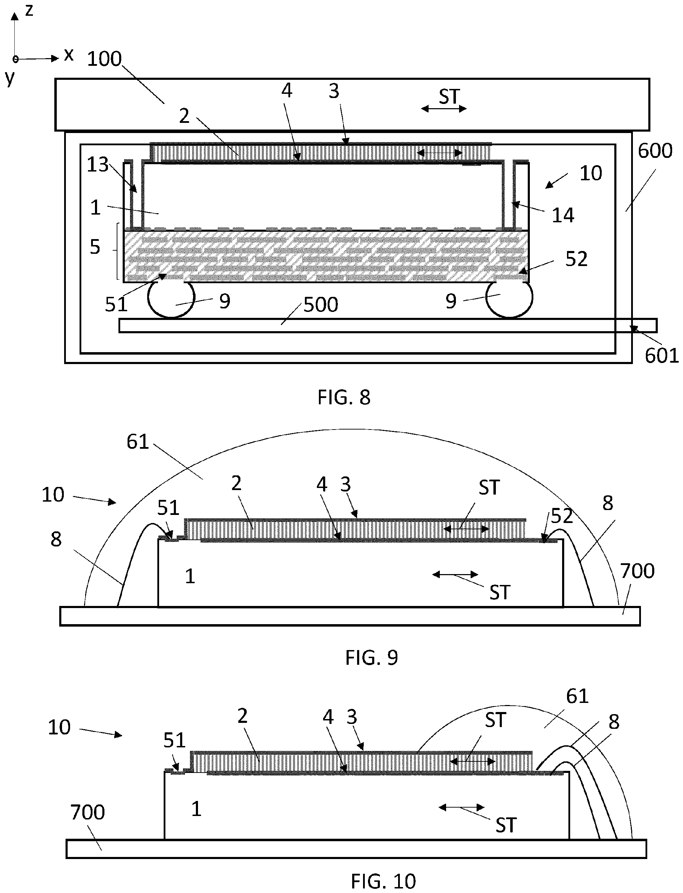

Figure 8 illustrates a strain sensor arrangement in cut view, according to an embodiment of the present invention. The strain sensor arrangement comprises a strain sensor 10 identical or similar to the strain sensor 10 shown in Figure 4 which is arranged by its top electrode 4 or a passivation layer arranged thereon directly on an inner wall of a housing 600 which in turn is mounted to a component 100. Accordingly, as to the orientation of the strain sensor 10 with respect to the component 100, the arrangement is identical to the arrangement of Figure 7 in that the strain sensing layer 2 faces the component 100. Again, the component 100 is exposed to dynamic strain ST in direction of the double arrow, but not limited to. The strain sensor 10 is SMD mounted to a carrier, which in the present example is a flexible printed circuit board (PCB) 500. The mounting may include solder balls 9. By this means, an electrical connection is achieved between the strain sensor 10 and the flexible PCB 500 such that the processed strain signal may be available outside the strain sensor 10 and e.g. be conducted via the flexible PCB to a microcontroller either resident on the flexible PCB 500 or remote. The flexible PCB 500 in turn is lead to a connector 601 of the housing 600. The flexible PCB 500 is not necessarily fixed to the housing 600 other than to the connector 601.

Figure 9 illustrates a cut view of a strain sensor 10 according to a further embodiment of the present invention. As to the substrate 1 and the strain sensing layer 2 arrangement, the strain sensor 10 of Figure 9 is identical or strongly resembles the strain sensor 10 of Figure 1. However, the substrate 1 preferably is arranged on a printed circuit board PCB 700. The top and bottom electrodes 3,4 are electrically connected to the PCB 700 by means of bond wires 8. This arrangement is protected by means of a glob top 61 which encapsulates the substrate 1, the strain sensing layer 2 and the bond wires 8, and, hence, protects these elements from mechanical and other environmental impact.

Figure 10 illustrates a cut view of a strain sensor 10 according to a further embodiment of the present invention. The strain sensor 10 of Figure 10 is identical or strongly resembles the strain sensor 10 of Figure 9, except for the shape of the glob top 61 and the arrangement of the bond wires 8. According to Figure 10, the bond wires 8 are arranged at a common side of the substrate 1. The glob top 61 only covers the bond wires 8 and a portion of the substrate 1 and the strain sensing layer 2.

## Claims

1. Strain sensor, comprising:
- a substrate (1),
- a strain sensing layer (2):
o of polycrystalline piezoelectric material,
o supported by the substrate (1) and extending in a plane in parallel to a plane (x,y) of the substrate (1),
o arranged between a top electrode (3) and a bottom electrode (4), each extending in parallel to the plane (x,y) of the substrate (1),
o of a thickness of less than or equal to 2 µm perpendicular to its plane extension,
o linked with the substrate (1) to have strain (ST) in the plane (x,y) of the substrate (1) couple into the strain sensing layer (2) as in-plane strain (ST),
- wherein the polycrystalline piezoelectric material is configured to convert the in-plane strain (ST) in the strain sensing layer (2) into an electric field (EF) perpendicular to the plane of the strain sensing layer (2), resulting in a difference of potential between the top electrode (3) and the bottom electrode (4) representing a strain signal.

2. Strain sensor according to claim 1, wherein the strain sensing layer (2) comprises or consists of aluminium nitride.

3. Strain sensor according to claim 2,
wherein the strain sensing layer (2) is an alloy and comprises scandium in addition to the aluminium nitride,
preferably wherein the strain sensing layer (2) comprises equal to or less than 50% scandium, preferably equal to or less than 45% scandium, more preferably equal to or less than 30% scandium.

4. Strain sensor according to any of the preceding claims,
wherein the polycrystalline piezoelectric material comprises crystallites with a c-axis oriented perpendicular to the plane (x,y) of the substrate (1),
preferably wherein a majority of crystallites of the polycrystalline piezoelectric material show a c-axis oriented perpendicular to the plane (x,y) of the substrate (1).

5. Strain sensor according to any of the preceding claims,
wherein each of the top electrode (3) and the bottom electrode (4) comprises or consists of molybdenum, and
wherein a thickness of each of the top electrode (3) and bottom electrode (4) perpendicular to its plane extension is between 100 nm and 1 µm, preferably between 200 nm and 500 nm.

6. Strain sensor according to any of the preceding claims,
comprising a seed layer (21) of the same polycrystalline piezoelectric material the strain sensing layer (2) is made from,
wherein the seed layer (21) is arranged on the substrate (1) and in contact with the bottom electrode (4),
preferably wherein the seed layer (21) has a thickness between 10 nm and 50 nm perpendicular to its plane extension.

7. Strain sensor according to a combination of claims 2, 5 and 6,
wherein the polycrystalline piezoelectric material comprises or is made from aluminium nitride,
wherein the bottom electrode (4) comprises or is made from molybdenum,
wherein the seed layer (21) comprises or is made from aluminium nitride,
preferably wherein the top electrode (3) comprises or is made from aluminium or from molybdenum.

8. Strain sensor according to any of the preceding claims,
wherein the thickness of the strain sensing layer (2) is between 100 nm and 2 µm.

9. Strain sensor according to any of the preceding claims,
wherein at least the portion of the substrate (1) the strain sensing layer (2) is linked with or is attached to represents bulk substrate material absent any undercut or recess therein,
wherein the substrate (1) is a semiconductor substrate,
preferably wherein the substrate (1) is a silicon substrate,
preferably wherein the silicon substrate (1) has an orientation of <001> in Miller indices.

10. Strain sensor according to any of the preceding claims,
wherein the mounting between the strain sensing layer (2) and the substrate (1) is configured to prevent from a relative motion between the strain sensing layer (2) and the substrate (1),
preferably wherein a thickness of the substrate (1) is equal to or less than 950 µm, preferably equal to or less than 300 µm,
preferably wherein the thickness of the substrate (1) is equal to or more than 50 µm, preferably equal to or more than 90 µm.

11. Strain sensor according to any of the preceding claims,
comprising a protection layer (6),
preferably wherein the protection layer is one of a mold compound (60) and a glob top (61),
preferably wherein the protection layer (6) encapsulates parts of the substrate (1),
preferably wherein the protection layer (6) covers the top electrode (3),
preferably wherein a thickness of the portion of the protection layer covering the top electrode (3) is equal to or less than 5 mm, preferably is equal to or less than 2 mm, preferably between 300 µm and 600 µm.

12. Strain sensor according to any of the preceding claims,
wherein the strain sensing layer (2) is linked with the substrate (1) by being deposited on the substrate (1) or on the bottom electrode (4) across an area of at least 1 mm².

13. Strain sensor arrangement, comprising
a component (100),
a strain sensor (10) according to any of the preceding claims for measuring in-plane strain (ST) of the component (100),
preferably wherein the strain sensor (100) is attached to the component (1000) to join in a displacement or a deformation of the component (1000) in a perpendicular direction (z) without being compressed in the perpendicular direction (z),
preferably wherein the component (100) is the component (100) of one of a machine, a tool, a production site, an infrastructure, an engine, a pump, a turbine, a bearing, a housing, a container, a building, a gear, a transportation means, a vehicle, a heater, a burner and a boiler.

14. Strain sensor arrangement according to claim 13,
wherein the strain sensor (10) is mounted to the component (100) by one or more mounting elements (9, 500) attaching the strain sensor (10) to at least two mounting points in the plane (x,y),
in particular absent any mounting elements retaining the strain sensor (10) and/or its strain sensing layer (2) at a perpendicular position (z).

15. Use of a strain sensor (10) according to any of the preceding claims 1 to 12 for one or more of:
- measuring strain of a component, preferably of a component of or a component coupled to one of a machine, a tool, a production site, an infrastructure, an engine, a pump, a turbine, a bearing, a housing, a container, a building, a gear, a transportation means and a vehicle,
- monitoring a condition and / or a quality of a component, or the condition and / or a quality of a machine, a tool, a production site, infrastructure, an engine, a pump, a turbine, a bearing, a housing, a container, a building, a gear, a transportation means or a vehicle the component is comprised in or is coupled to,
- predicting maintenance operations of a component or of a machine, a tool, a production site, infrastructure, an engine, a pump, a turbine, a bearing, a housing, a container, a building, a gear, a transportation means or a vehicle the component is comprised in or is coupled to,
- measuring structure borne sound and / or noise, in particular measuring road noise and / or monitoring the condition and / or quality of a road based on the measured noise, by mounting the strain sensor on a vehicle, in particular measuring a status of one of a heater, a burner and a boiler, in particular measuring structure borne sound and / or noise on a living being, preferably on a human being, by way of coupling the strain sensor to a living being, preferably implementing a hearing aid and / or noise cancellation for the living being.

16. Method for operating a strain sensor according to any of the preceding claims 1 to 12, comprising
- attaching the strain sensor (10) to a component (100) such that in-plane strain in the component is coupled into in-plane strain in the strain sensing layer (2),
- receiving a strain sensor signal from the strain sensor (10),
- evaluating the strain sensor signal,
- determining an index of condition and / or an index of quality dependent on the evaluation of the strain sensor signal,
- performing one or more of the following steps:
o displaying the determined index;
o providing a recommendation to an operator subject to the determined index;
o adjusting a process for operating the component or a system coupled to the component subject to the determined index.
